# EUROPEAN PATENT APPLICATION

(11) **EP 2 267 196 A1**
(43) Date of publication of application: **29.12.2010**
(21) Application number: 09732518.7
(22) Date of filing: 14.04.2009
(51) Int. Cl.: C30B 29/38

(54) **METHOD OF GROWING ALN CRYSTALS, AND ALN LAMINATE**

(30) Priority: 17.04.2008 JP 2008108161; 30.03.2009 JP 2009082422
(71) Applicant: Sumitomo Electric Industries, Ltd., Chuo-ku Osaka-shi Osaka 541-0041 (JP)
(72) Inventor: TANIZAKI, Keisuke, Itami-shi Hyogo 664-0016 (JP); MIZUHARA, Naho, Itami-shi Hyogo 664-0016 (JP); MIYANAGA, Michimasa, Osaka-shi Osaka 554-0024 (JP); SATOH, Issei, Itami-shi Hyogo 664-0016 (JP); NAKAHATA, Hideaki, Itami-shi Hyogo 664-0016 (JP); YAMAMOTO, Yoshiyuki, Itami-shi Hyogo 664-0016 (JP)
(74) Representative: Grünecker, Kinkeldey, Stockmair & Schwanhäusser Anwaltssozietät
(86) International application number: PCT/JP2009/057472
(87) International publication number: WO 2009/128434

(57) **Abstract**

Affords an AlN crystal growth method, and an AlN laminate, wherein AlN of favorable crystalline quality is grown.

The AlN crystal growth method is provided with the following steps. To begin with, a source material (17) containing AlN is prepared. A heterosubstrate (11), having a major surface (11*a*), is prepared. The source material (17) is sublimed to grow AlN crystal so as to cover the major surface (11*a*) of the heterosubstrate (11), whereby a first layer (12) with a flat face (12*a*) is formed. The source material (17) is sublimed to form onto the face (12*a*) of the first layer (12) a second layer (13) made of AlN. The second layer (13) is formed at a higher temperature than is the first layer (12).

## Description

### Technical Field

The present invention relates to methods of growing AlN crystal, and to AlN crystal laminates.

### Background Art

Aluminum nitride crystal (AlN), because it has a broad energy bandgap of 6.2 eV, a high thermal conductivity of approximately 3.3 WK⁻¹ cm⁻¹, and high electrical resistance, has received attention as a substrate material for semiconductor devices including optoelectronic and other microelectronic devices.

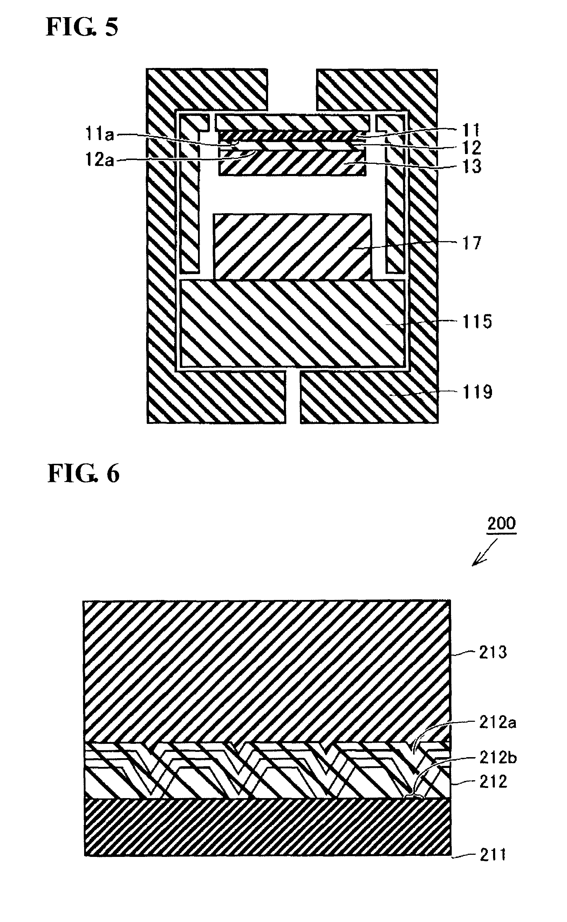

A known way to grow such AlN crystal is a technique whereby the AlN crystal is grown by sublimation deposition (for example, Non-Patent Reference 1). Fig. 6 is a sectional diagram representing, in simplified form, the situation when AlN crystal has been grown according to Non-Patent Reference 1. Referring to Fig. 6, AlN crystal growth according to Non-Patent Reference 1 is for example implemented by the following steps. Namely, an AlN polycrystal source material is placed in the lower part of a growth chamber, and on a pedestal in the upper part of the growth chamber, an SiC (silicon carbide) substrate, as a seed template 211, is placed so that it and the AlN polycrystal source material will face each other. After that, as the first growth stage, sublimation of the AlN polycrystal source material is carried out at a temperature of just under 1900°C, to grow onto the face of the seed template 211, at a growth rate of 10 to 30 µm/h, a layer 212 in which the AlN crystal grains have fused. After this fused layer 212 has sufficiently formed, the temperature is slowly ramped up 100 to 200°C. Then, as the second growth stage, growth of AlN crystal 213 onto the surface of the fused layer 212 is carried out, at a growth rate of 70 µm / h.

### Citation List

*Non-Patent Reference 1:* R. Dalmau et al., "AlN Bulk Crystals Grown on SiC Seeds," Journal of Crystal Growth, vol. 281, 2005, pp. 68-74.

### Summary of Invention

### Technical Problem

Non-Patent Reference 1 discloses the rocking-curve full-width at half-maximum (FWHM) in (002)-plane x-ray diffractometry on AlN crystal 213 grown by the method just described being 456 to 1440 arcsec. The FWHM figure was high, which meant that the crystalline quality of the AlN crystal 213 was poor. The reason why is speculated to be as follows. The crystal grains in the fused layer 212 grown in the first growth stage melt together.
At the interfaces where the crystal grains fuse, pits 212*a* form, and defects develop in the pits 212*a*. On that account, presumably, the crystalline quality of the AlN crystal 213 over the defects is spoiled.

Accordingly, the present invention is to make available an AlN crystal growth method, and an AlN laminate, wherein AlN of favorable crystalline quality is grown.

### Solution to Problem

An AlN crystal growth method of the present invention is provided with the following steps. To begin with, a source material containing AlN is prepared. A heterosubstrate, having a major surface, is prepared. The source material is sublimed to grow AlN crystal so as to cover the major surface of the heterosubstrate, whereby a first layer with a flat face is formed. The source material is sublimed to form onto the face of the first layer a second layer made of AlN. The second layer is formed at a higher temperature than is the first layer.

By way of an AlN crystal growth method of the present invention, the face of the first layer is flat, which serves to keep pits from forming due to fusing of the crystal grains. Therefore, by growing the second layer onto the face, dislocations originating in pits in the first layer can be kept from being formed. Growing a second layer made of AlN of favorable crystalline quality is consequently possible.

Here, the aforementioned "face being flat" means that the face of the first layer covers, in a continuous state, the entire major surface of the heterosubstrate. A "discontinuous state" is a state in which areas are present where, as with the fused areas disclosed in Patent Reference 1, AlN crystal along the major surface of the heterosubstrate has not grown continuously (for example, the areas 212*b* in Fig. 6 where a separate film has formed in which crystal grains have melted together).

With the above-described AlN crystal growth method, in the step of forming a first layer, preferably a first layer containing a Group 4B impurity(ies) is formed.

The present inventors discovered that if the first layer is grown containing a Group 4B impurity(ies), a first layer is grown in which the growth horizontally is at a faster rate than the growth vertically. A first layer with a flat face can thereby be grown. Inasmuch as onto a flat face a favorable-crystalline-quality second layer can be grown, a second layer made of AlN of excellent crystalline quality can be grown.

With the above-described AlN crystal growth method, in the step of forming a first layer, preferably the first layer is formed so that the impurity concentration will be 10¹⁸ atoms•cm⁻³ or greater.

A first layer with a flatter face can thereby be grown. A second layer of more favorable crystalline quality can therefore be grown.

With the above-described AlN crystal growth method, in the step of forming a second layer, preferably a second layer containing a Group 4B impurity(ies) is formed.

In forming the first layer, there will be instances in which, since it is formed so as to contain a Group 4B impurity(ies), the second layer thus will substantially contain the Group 4B impurity(ies).

With the above-described AlN crystal growth method, in the step of forming a second layer, preferably the second layer is formed so that the impurity concentration will be less than 10¹⁸ atoms•cm⁻³. A second layer of more favorable crystalline quality can therefore be grown.

With the above-described AlN crystal growth method, preferably the form of the impurity(ies) is at least either spherical or polyhedral.

Since this allows the surface area of the impurities to be minimized, the first layer can be grown so as to take in the impurities little by little. In implementations where the first layer contains an impurity(ies), nonetheless the crystalline quality of the first layer can therefore be kept from deteriorating.

With the above-described AlN crystal growth method, in the step of preparing the source material, preferably a source material in which the relative density of the AlN is between 0.20 and 0.55 is prepared.

With the AlN relative density being 0.20 or greater, the AlN particles will not be overly tiny, while their surface area will not be overly large. Since the area of contact of the AlN particles with oxygen will therefore not be overly extensive, the quantity of oxygen adsorbed will not be large. The incorporating of aluminum oxide, with oxygen being adsorbed as an impurity, into the source material that is prepared may therefore be reduced. Accordingly, the taking of oxygen as an impurity into the first and second layers that are grown can be kept under control. The crystalline quality of the second layer can be further improved as a result. Meanwhile, with the AlN relative density being not greater than 0.55, the space between the AlN particles in the source material may be kept from being restrictive. This facilitates securing pathways that allow the sublimation gases, generated by the source-material AlN being sublimed, to travel toward the heterosubstrate. The growth rate can therefore be enhanced.

Here, the aforementioned "relative density" means: (density of AlN within source material prepared/given theoretical density of AlN).

With the above-described AlN crystal growth method, in the step of forming a first layer, preferably a first layer having a thickness of 300 µm or greater is formed.

By making the thickness of the first layer be 300 µm or greater, the face of the first layer can be made still flatter. A second layer whose crystalline quality is further favorable can therefore be grown.

In the above-described AlN crystal growth method, preferably the temperature is raised from the step of forming a first layer until the step of forming a second layer in such a way that the temperature ramp therein will be 1°C/minute or less.

The occurrence of cracks due to difference between the thermal expansion coefficient of the heterosubstrate and the thermal expansion coefficient of the first layer can thereby be kept under control.

Here, the just-mentioned "temperature ramp" means (second-layer formation temperature - first-layer formation temperature) / (time from after termination of the step of forming the first layer until commencement of the step of forming the second layer).

An AlN laminate of the present invention is an AlN laminate grown by an AlN crystal growth method set forth in any of the foregoing descriptions, wherein the laminate is provided with a heterosubstrate, a first layer formed onto the heterosubstrate, and a second layer formed onto the first layer.

In accordance with an AlN laminate of the present invention since the face of the first layer is flat, the second layer formed onto that face makes it possible to keep dislocations originating in pits in the first layer from forming. An AlN laminate furnished with a second layer made of AlN of excellent crystalline quality may therefore be realized.

In the above-described AlN laminate, the second layer preferably has a diameter of 25 mm or greater. More preferably, the second layer has a diameter of 50 mm or greater. All the more preferably, the second layer has a diameter of 100 mm or greater.

Large-gauge AlN laminates of superior utility may therefore be realized. It should be noted that in the present specification, "Group 4B" signifies Group IVB in the former IUPAC (International Union of Pure and Applied Chemistry) system. In particular, "Group 4B" indicates C (carbon), Si (silicon), Ge (germanium), Sn (tin) and Pb (lead).

### Advantageous Effects of Invention

In accordance with an AlN crystal growth method and an AlN laminate of the present invention, forming a first layer having a flat face enables a second layer on the face to be grown as AlN of excellent crystalline quality.

### Brief Description of Drawings

Fig. 1 is a sectional diagram representing, in simplified form, an AlN laminate in a mode of embodying the present invention.
Fig. 2 is a flowchart outlining an AlN crystal growth method in the mode of embodying the present invention.
Fig. 3 is a chart illustrating the relationship between time and temperature for the growth of AlN crystal in the mode of embodying the present invention.
Fig. 4 is a simplified view representing a crystal-growth apparatus employed in Embodiment 1.
Fig. 5 is an enlarged view of a key unit of the crystal-growth apparatus in
Fig. 4.
Fig. 6 is sectional diagram representing, in simplified form, the situation when AlN crystal has been grown according to Non-Patent Reference 1.

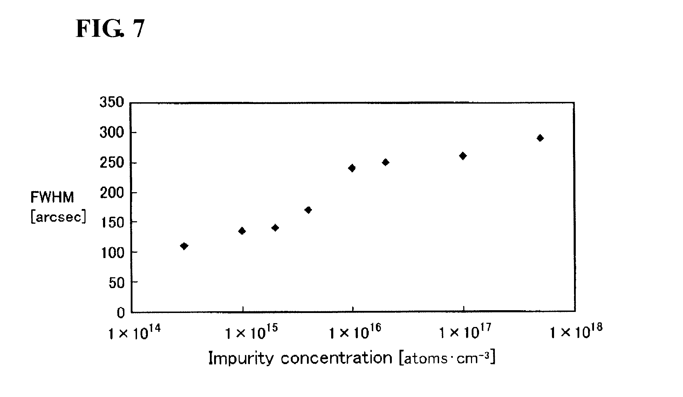

Fig. 7 is a chart illustrating the relationship between impurity concentration in, and FWHM for, the second layer, in Embodiment 2.

### Description of Embodiments

Below, a description of a mode of embodying, and of embodiments of, the present invention will be made based on the drawings. It should be understood that in the following, identical or corresponding parts in the drawings are labeled with identical reference marks, and their description will not be repeated.

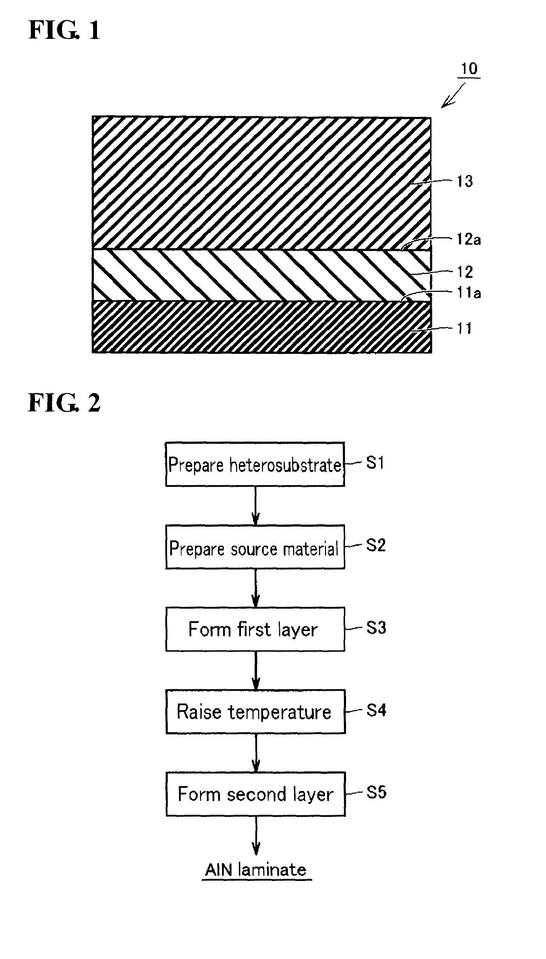

Fig. 1 is a sectional diagram representing, in simplified form, an AlN laminate in the present embodying mode. Referring to Fig. 1, a description of an AlN laminate 10 in the present embodying mode will be made.

The AlN laminate 10 comprises a heterosubstrate 11, a first layer 12, and a second layer 13. The heterosubstrate 11 has a major surface 11*a*. The first layer 12 is formed onto the major surface 11*a*, and has a first face 12*a*. The second layer 13 is formed onto the first face 12*a*.

The heterosubstrate 11 consists of a material other than AlN, such as SiC (silicon carbide), for example. The heterosubstrate 11 has a diameter of, for example, 25 mm or greater, preferably 50 mm or greater, and more preferably has a diameter of 100 mm or greater.

The first face 12*a* of the first layer 12 is flat. That is, it is in a state in which it continuously covers the entire major surface 11*a* of the heterosubstrate 11. In a thus flat first face 12*a* almost no indentations-arising on account of, for example, imperfect fusing of grains-form.

The first layer 12 contains AlN as the chief component, and a Group 4B impurity(ies). In the first layer 12 the concentration of impurities is, for example, 1.0 × 10¹⁸ atoms•cm⁻³ or greater, preferably 1.5 × 10²⁰ atoms•cm⁻³ or greater. Here, the upper-limit value for the concentration of impurities contained in the first layer 12 is, from the perspective of not compromising the crystalline quality of the first layer 12, not greater than 3.5 × 10²⁰ atoms•cm⁻³, for example.

And the thickness of the first layer 12 is, for example, 300 µm or greater. The upper limit is, from the perspective of heightening the efficiency with which the AlN laminate 10 is manufactured, 500 µm, for example.

The second layer 13 is made of AlN. While the second layer 13 preferably does not contain impurities, it may contain unavoidable impurities such as Group 4B impurities. The concentration of Group 4B impurities contained in the second layer 13 preferably is lower than the concentration of Group 4B impurities contained in the first layer 12. Furthermore, it is the more preferable the fewer are the Group 4B impurities contained in the second layer 13-for example, fewer than 1.0 × 10¹⁸ atoms•cm⁻³ and preferably not more than 1.0 × 10¹⁶ atoms•cm⁻³.

The thickness of the second layer 13 is, for example, 1 mm or greater, preferably 2 mm or greater. The diameter of the second layer 13 is, for example, 25 mm or greater, preferably 50 mm or greater, more preferably 100 mm or greater.

Here, the concentration of Group 4B impurities contained in the first and second layers 12 and 13 is a value determined by SIMS (secondary ion mass spectroscopy), for example.

Fig. 2 is a flowchart outlining an AlN crystal growth method in the present embodying mode. To continue: Referring to Fig. 2, a description of a method of growing AlN crystal in the present embodying mode will be made.

To begin with, a heterosubstrate 11 having a major surface 11*a* is prepared (Step S1). The heterosubstrate 11 serves as a seed substrate for the growth of AlN crystal on the major surface 11*a*. While the heterosubstrate 11 that is prepared is not particularly limited as long as it is of a material that differs from AlN, from the perspective of growing AlN crystal of favorable crystalline quality, an SiC substrate or the like is preferably employed.

Again, in Step S1, a heterosubstrate 11 having a diameter of, for example, 25 mm or greater, preferably 50 mm or greater, and more preferably having a diameter of 100 mm or greater is prepared. In that case, in later-described Step S5 of forming a second layer 13, a large-area second layer 13 can be grown.

Next, a source material containing AlN is prepared (Step S2). The AlN contained in the source material is, for example, AlN polycrystal. Powdered AlN, cast AlN and calcined AlN are examples of the form that the polycrystal AlN utilized may take.

In instances where the source material is an AlN casting or a calcined AlN preform, the relative density of the source-material AlN preferably is between 0.20 and 0.55, more preferably between 0.30 and 0.55. With the relative density being 0.20 or greater, the AlN particles will not be overly tiny, such that their surface area will not be overly large. Since the area of contact of the AlN particles with oxygen will therefore not be overly extensive, the quantity of oxygen adsorbed onto the AlN will not be large. The incorporating of aluminum oxide, with oxygen being adsorbed as an impurity, into the source material that is prepared may therefore be reduced. Accordingly, in the later-described step of growing first and second layers 12 and 13 the taking of oxygen into the first and second layers 12 and 13 can be kept under control. The crystalline quality of the second layer 13 can be further improved as a result. In instances where the relative density is 0.30 or greater, the crystalline quality of the second layer 13 can be further improved. On the other hand, with the relative density being not greater than 0.55, the space between the numerous AlN particles in the source material may be kept from being restrictive. This facilitates securing pathways in order for the sublimation gases generated by the sublimation of the source-material AlN to travel toward the heterosubstrate. The rate of the later-described growth of first and second layers 12 and 13 can therefore be enhanced.

Herein, the aforementioned relative density indicates a value found from: (density of AlN within source material prepared) ÷ (given theoretical density of AlN). The density of the AlN within the source material that is prepared is a value determined, for example, according to Archimedes' principle.

In the step of preparing a source material in the present embodying mode, a source material containing AlN and a Group 4B impurity is prepared. The Group 4B impurity is, for example, at least one substance among C, Si, Ge, Sn and Pb. The impurity(ies) may be two or more types of substances, or may be a substance of a single kind. In particular, it is preferable that the Group 4B impurity be carbon. In instances where the Group 4B impurity is carbon, preferably the C source contains at least graphitic structures, and is pure elemental carbon such as carbon black or graphite.

The form of the impurity(ies) preferably is at least either spherical or polyhedral, with rectangular shapes being further preferable. The fact that in these cases the surface area of the impurities can be lessened makes it possible, in the later-described growing of a first layer 12, to have the first layer 12 take in the impurities little by little, without the crystalline quality being degraded. And it is especially preferable that the impurities be in the form of rectangular bodies, since the surface area can be lessened more than with other polyhedral or spherical forms. In implementations predetermining the mass of the distributed impurity(ies), better than a powder of micro-particles of 100 µm or less diameter, a powder in the form of beads of 101 µm or greater diameter is ideally utilized.

Next, the source material is sublimed to grow AlN crystal so as to cover the major surface 11*a* of the heterosubstrate 11, whereby a first layer 12 with a flat face 12*a* is formed (Step S3). The method whereby the AlN crystal is grown is not particularly limited as long as it is a vapor-phase growth technique; a technique such as sublimation growth, HVPE (hydride vapor phase epitaxy), MBE (molecular beam epitaxy), or MOCVD (metalorganic chemical vapor deposition) for example may be adopted. In particular, growing the AlN crystal by sublimation deposition is preferable, because it is suited to growth of AlN crystal.
In the present embodying mode, the first layer 12 is formed by sublimation growth, for example.

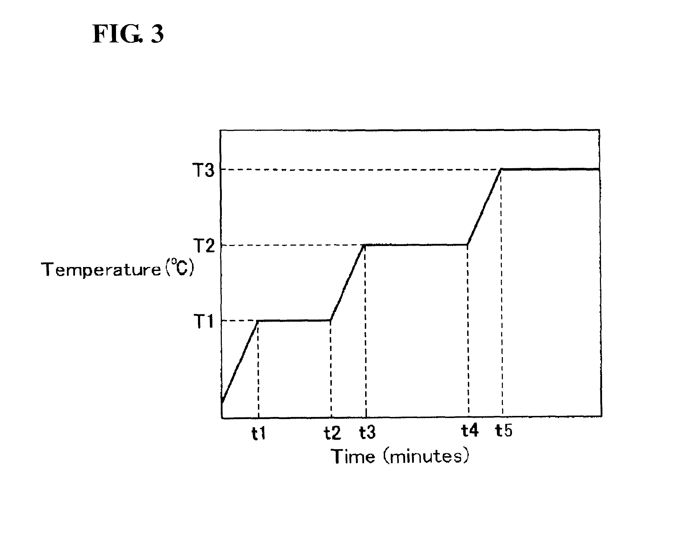

Fig. 3 is a chart illustrating the relationship between time and temperature for the growth of AlN crystal in the present embodying mode. As indicated in Fig. 3, the source material is heated, for example, at temperature *T₁*°C for a time of (*t₂* - *t₁*) minutes. The heating sublimes the source material, generating sublimation gases, and the sublimation gases are sent to the major surface 11*a* of the heterosubstrate 11, which is set to a temperature lower than that of the source material. The sublimation gases recrystallize over the major surface 11*a* of the heterosubstrate 11, whereby the first layer 12 is formed.

The temperature *T₁* at which the first layer 12 is grown is the temperature at which the AlN contained in the source material sublimes, and is between 1800°C and 2100°C for example.

The temperature *T₁* for forming the first layer 12 preferably is made a temperature that keeps the heterosubstrate from subliming. Since in that case sublimation of the heterosubstrate 11 is kept under control, onto the major surface 11*a* of the heterosubstrate 11, a first layer 12 having an area that is equal to that of the area of the major surface 11*a* of the heterosubstrate 11 can be grown. A large-area first layer 12 can therefore be grown.

In implementations where the source material contains AlN and a Group 4B impurity(ies), the AlN as well as the impurities will be sublimed by heating. In Step S3 of forming a first layer 12, it is preferable to conduct the growth until all of the Group 4B impurities within the prepared source material sublime. The impurities may be intermixed with the AlN or may be arranged separately from the AlN, or a portion of the impurities may be intermixed with the AlN, and the remaining portion of the impurities arranged separately from the AlN.

The first layer 12 is grown in such a way that the concentration of the impurities will be 1.0 × 10¹⁸ atoms•cm⁻³ or greater, preferably 1.5 × 10²⁰ atoms•cm⁻³ or greater. Here, the upper-limit value for the concentration of impurities contained in the first layer 12 is, from the perspective of not compromising the crystalline quality of the first layer 12, not greater than 3.5 × 10²⁰ atoms•cm⁻³, for example.

Furthermore, the first layer 12 is grown so as to have a thickness of, for example, 300 µm or greater. From the perspective of heightening the efficiency with which the first layer 12 is manufactured as an AlN laminate 10, the upper limit of its thickness is 500 µm, for example.

Carrying out Step S3 grows the first layer 12 globally covering the major surface 11*a* of the heterosubstrate, and thus the face 12*a* turns out flat. When the first layer 12 is grown so as, in particular, to contain a Group 4B impurity, a first layer 12 is grown in which the growth horizontally is at a faster rate than the growth vertically. A first layer 12 having a flat face 12*a* can therefore be grown.

Next, the temperature is raised (Step S4) from temperature *T₁* up to a temperature *T₂* , as indicated in Fig. 3, at which the second layer 13 is grown. In Step S4 the temperature ramp [(*T₂* - *T₁*)/(*t₃* - *t₂*)] is preferably made 1°C/minute or less. In that case, cracks due to difference between the thermal expansion coefficient of the heterosubstrate 11 and the thermal expansion coefficient of the first layer 12 can effectively be kept from occurring in the first layer 12.

Next, the source material is sublimed to form onto the face 12*a* of the first layer 12 a second layer 13, made of AlN. The second layer 13 is formed at a higher temperature, *T₂*, than temperature *T₁* at which the first layer 12 is formed.

With the face 12*a* of the first layer 12 being flat, pits where crystal grains have fused do not, for the most part, form. Since the second layer 13 is grown onto a flat face 12*a*, dislocations originating in pits in the face 12*a* of the first layer 12 can be kept from forming. And since the second layer 13 is grown at higher temperature than is the first layer 12, the growth rate is rapid. Accordingly, the second layer 13 has a fast growth rate, and is of excellent crystalline quality.

Specifically, the source material is heated for example at temperature *T₂*°C for time (*t₄* - *t₃*) minutes. This heating sublimes the source material, generating sublimation gases to grow AlN crystal on the face 12*a* of the first layer 12 having been grown onto the heterosubstrate 11, which is set to a temperature lower than that of the source material. A second layer 13 is thereby formed.

The temperature *T₂* at which the second layer 13 is grown is a temperature such as to heighten the rate at which the second layer 13 grows, and is between 1900°C and 2300°C, for example.

In Step S5, the second layer 13 preferably is grown so as not to incorporate impurities. The second layer 13 may, however, contain unavoidable impurities. Implementations in which in Step S3 of forming a first layer 12, the first layer 12 is grown so as to contain Group 4B impurities, preferably are controlled so that almost all the impurities prepared in Step S3 of forming a first layer 12 are taken into the first layer 12, and so that the impurities prepared in Step S5 of forming a second layer 13 are not taken into the second layer 13. In other words, it is preferable that impurities taken into the second layer 13 are fewer than impurities taken into the first layer 12. In implementations where the impurities are taken into the second layer 13, the second layer 13 is grown so that the Group 4B impurities contained in the second layer 13 will be fewer than 1.0 × 10¹⁸ atoms•cm⁻³ and preferably not more than 1.0 × 10¹⁶ atoms•cm⁻³.

By increasing the growth time (*t₂* - *t₁*) in Step S3 of forming a first layer with a flat face, when the first layer 12 is formed, impurities contained within the source material can be consumed, so as to reduce, in the manner just noted, the concentration of impurities in the second layer 13.

Further, the second layer 13 is grown so as to have a thickness of, for example, 1 mm or greater, preferably 2 mm or greater. Likewise, the second layer 13 is grown so as to have a diameter of, for example, 25 mm or greater, preferably 50 mm or greater, more preferably 100 mm or greater.

Carrying out the foregoing Steps S1 through S5 makes it possible to manufacture the AlN laminate 10 represented in Fig. 1.

Here, the AlN crystal grow method of the present embodying mode manufactures an AlN laminate furnished with first and second layers 12 and 13 by elevating the growth temperature in two stages, but is not particularly limited to that. With an AlN crystal growth method of the present invention, an AlN laminate furnished with one or more additional layers atop the second layer 13 may be manufactured by elevating the growth temperature stepwise in three or more stages.
In an exemplary implementation in which a third layer made of AlN is formed onto the face of the second layer 13, the following steps are, for example, carried out.

Specifically, in a manner similar to Step S4 the temperature is raised from temperature *T₂* up to a temperature *T₃* , as indicated in Fig. 3, at which a third layer is grown. Subsequently, the third layer is grown at temperature *T₃* onto the face of the second layer 13.

In an implementation in which a plurality of layers is to be formed onto the second layer 13, for example the operation just described is repeated. The growth rate will be faster the higher the heating temperature is, whereby efficiency for the sake of manufacturing AlN laminates improves.

As explained in the foregoing, according to an AlN crystal growth method of the present embodying mode, a Step S3 of forming a first layer 12 with a flat face 12*a*, and a Step S5 of forming a second layer 13 made of AlN onto the face 12*a* of the first layer 12 are provided, wherein the second layer 13 is formed at a higher temperature than is the first layer 12. The fact that the face 12*a* of the first layer 12 is flat keeps the formation of pits due to crystal-grain fusion under control. Consequently, growing the second layer 13 onto the face 12*a* makes it possible to keep dislocations originating in pits in the first layer 12 (for example, the pits 212*a* in Fig. 6) from forming. A second layer 13 made of AlN of favorable crystalline quality can accordingly be grown.

Meanwhile, since the first layer 12 is grown at a low temperature, with the heterosubstrate 11 being kept from subliming, an AlN film can be grown on the major surface 11*a* of the heterosubstrate 11. The AlN film protects the heterosubstrate 11, which keeps damage from being imparted to the heterosubstrate 11. The fact that a first layer 12 can therefore be grown onto the major surface 11*a* of the heterosubstrate 11 enables a large-area first layer 12 to be grown. The area of the second layer 13 that is grown onto the face 12*a* of the first layer 12 can be enlarged as a result. Furthermore, the fact that the crystalline quality of the second layer 13 is, as has been noted earlier, favorable means that a second layer 13 made of AlN single-crystal of superior crystalline quality and that is uniform in-plane can be grown.

In addition, the second layer 13 can be grown at a higher temperature than the first layer 12 is. The rate at which the second layer 13 grows can therefore be enhanced.

In the AlN crystal growth method described above, preferably a first layer 12 containing a Group 4B impurity(ies) is formed. In that case, a first layer 12 having a flat face 12*a* can be grown.

Since a second layer 13 obtained in this way is of excellent crystalline quality, it can find ideal utilization, for example, in light-emitting diodes, laser diodes, and other light-emitting devices, in rectifiers, bipolar transistors, field-effect transistors, HEMTs and other microelectronic devices, in temperature sensors, pressure sensors, radiation sensors, visible-blind ultraviolet detectors and other semiconductor sensors, and in SAW and like devices.

### Embodiment 1

In the present embodiment, the effects of providing Step S3 of forming a first layer with a flat face and Step S5 of forming a second layer made of AlN, and of forming the second layer at a higher temperature than the first layer is were investigated.

### Present Invention Example 1

To begin with, as the heterosubstrate, a 6H-SiC substrate having a two-inch diameter was prepared (Step S1).

Next a source material containing AlN and a Group 4B impurity(ies) was prepared (Step S2). In Step S2, initially a graphite powder having a grain size of 5 µm was mixed uniformly together with the AlN so as to be 3 mass % with respect thereto, and the mixture was hardened by HIP (hot isostatic pressing) until the relative density of the AlN became 0.80. Here, the relative density was found by Archimedes' principle. Thereafter the hardened mixture of graphite and AlN was calcined 15 hours at 2100°C. The post-calcining relative density of the AlN was unchanged. A calcined AlN preform with a carbon density of 0.7 mass % was thereby prepared.

It is to be noted that the aforementioned relative density is a value found from: (density of AlN within source material prepared) ÷ (given theoretical density of AlN). The density of the AlN within the source material that is prepared is a value determined by, for example, Archimedes' principle. And the AlN theoretical density was given as 3.28 g/cm³.

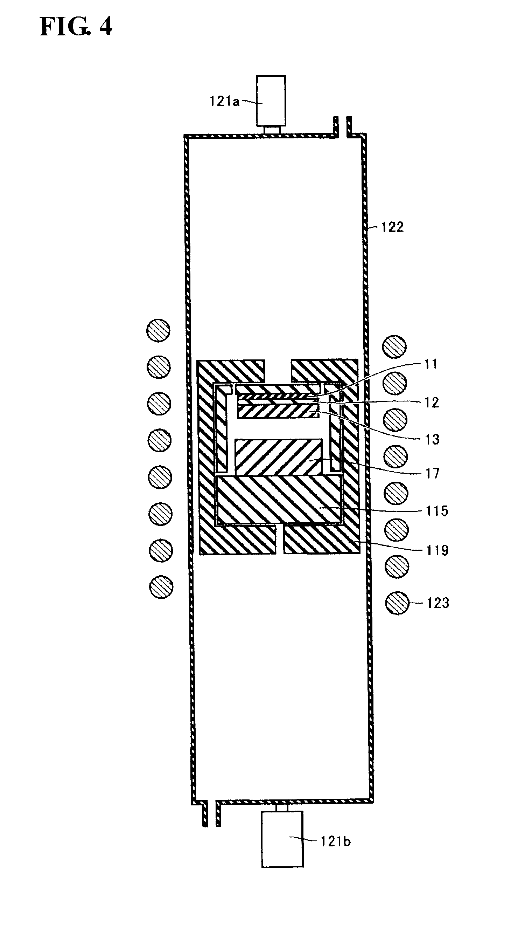

Fig. 4 is a simplified view representing a crystal-growth apparatus employed in the present embodiment. Fig. 5 is an enlarged view of a key unit of the crystal-growth apparatus in Fig. 4. The prepared heterosubstrate 11 was emplaced in the upper part of a crucible 115 in the reaction chamber 122 interior, as illustrated in Figs. 4 and 5, and the source material (calcined AlN preform) 17 was lodged into the lower part of the crucible 115. Here, the crystal-growth apparatus represented in Fig. 4 includes an insulating element 119 and radiation thermometers 121*a* and 121 b.

Next, the crystal-growth apparatus represented in Figs. 4 and 5 was employed to grow AlN crystal onto the major surface 11*a* of the heterosubstrate 11 by sublimation deposition, whereby a first layer 12 with a flat face was formed (Step S3).

Specifically, while gaseous nitrogen was flowed in the reaction chamber 122 interior, an RF-power heating coil 123 was employed to elevate the temperature inside the crucible 115 and bring the temperature of the heterosubstrate 11 to 1800°C and the temperature of the source material 17 to 2000°C, to sublime the source material 17 and recrystallize it over the major surface 11*a* of the heterosubstrate 11 and, by having the growth time be 30 hours, grow onto the heterosubstrate 11 a first layer 12, being AlN crystal, so as to have a thickness of 300 µm.

Next, the temperature was ramped up to 2100°C at a ramp rate of 1°C / min (Step S4). In turn, a second layer 13, made of AlN, was formed by sublimation growth onto the face 12*a* of the first layer 12 (Step S5).

Specifically, while gaseous nitrogen was flowed in the reaction chamber 122 interior, the RF-power heating coil 123 was employed to elevate the temperature inside the crucible 115 and bring the temperature of the heterosubstrate 11 to 1900°C and the temperature of the source material 17 to 2100°C, to sublime the source material 17 and recrystallize it over the face 12*a* of the first layer 12 and, by having the growth time be 100 hours, grow onto the face 12*a* of the first layer 12 a second layer 13, as AlN crystal, so as to have a thickness of 1 mm. The growth rate of the second layer 13 was 10 µm/hour.

It is to be noted that throughout the AlN crystal growth in Steps S3 and S5, gaseous nitrogen was continuously flowed inside the reaction chamber 122, with the amount of gaseous nitrogen exhausted being controlled so that the partial pressure of the gas in the reaction chamber 122 interior would be 10 kPa to 100 kPa.

Implementing the foregoing Steps S1 through S5 yielded an AlN laminate 10, as illustrated in Fig. 1, of the present Embodiment 1, furnished with a heterosubstrate 11, a first layer 12 formed onto the major surface 11*a* of the heterosubstrate 11, and a second layer 13 formed onto the face 12*a* of the first layer 12.

### Present Invention Example 2

The AlN crystal growth method of Present Invention Example 2 was provided with a makeup basically the same as that of the AlN crystal growth method of Present Invention Example 1, but differed in Step S2 of preparing the source material, and in Step S5 of forming a second layer 13.

Specifically, in Step S2 of preparing the source material, initially a graphite powder having a grain size of 5 µm was mixed uniformly together with the AlN so as to be 3 mass % with respect thereto. After that, the mixed substance was calcined 10 hours at 2100°C. A calcined AlN preform with a carbon density of 0.5 mass % and a relative density of 0.30 was thereby prepared.

And in Step S5 of forming a second layer 13, AlN crystal having a film thickness of 4.7 mm was grown. The growth rate of the second layer 13 was 50 µm / hour.

### Present Invention Example 3

The AlN crystal growth method of Present Invention Example 3 was provided with a makeup basically the same as that of the AlN crystal growth method of Present Invention Example I, but differed in Step S2 of preparing the source material.

Specifically, in Step S2 of preparing the source material, initially graphite having the form of a rectangular bar 1 mm deep, 1 mm wide, and 5 mm high was prepared. The graphite was mixed uniformly together with the AlN so as to be 3 mass % with respect thereto. Thereafter the mixed substance was calcined 10 hours at 2100°C. A calcined AlN preform with a carbon density of 0.7 mass % and a relative density of 0.30 was thereby prepared.

And in Step S5 of forming a second layer 13, AlN crystal was grown in the same way as with Present Invention Example 2. The growth rate of the second layer 13 was 50 µm/hour.

### Present Invention Example 4

The AlN crystal growth method of Present Invention Example 4 was provided with a makeup basically the same as that of the AlN crystal growth method of Present Invention Example 1, but differed in Step S2 of preparing the source material, and in Step S5 of forming a second layer 13.

Specifically, in Step S2 of preparing the source material, to begin with AlN alone was calcined 10 hours at 2100°C. The relative density of that calcined AlN preform was 0.30. Further, 0.7 mass %, with respect to the calcined AlN preform, graphite in the same rectangular-bar form as the graphite prepared in Present Invention Example 3 was prepared. The calcined AlN preform and the graphite were isolated and respectively accommodated in the lower part of the crucible 115.

And in Step S5 of forming a second layer 13, AlN crystal was grown in the same way as with Present Invention Example 2. The growth rate of the second layer 13 was 50 µm /hour.

### Present Invention Example 5

The AlN crystal growth method of Present Invention Example 5 was provided with a makeup basically the same as that of the AlN crystal growth method of Present Invention Example I, but differed in Step S2 of preparing the source material.

Specifically, to begin with a graphite powder having a grain size of 5 µm was mixed together with the AlN so as to be 3 mass % with respect thereto, and the mixture was hardened by HIP until the relative density became 0.56. Afterwards the hardened graphite and AlN mixture was calcined 15 hours at 2100°C. A calcined AlN preform with a carbon density of 0.7 mass % was thereby prepared.

Here, in Present Invention Example 5, in Step S5 of forming a second layer 13, the growth rate of the second layer 13 was 10 µm/hour.

### Comparative Example 1

With the AlN crystal growth method of Comparative Example 1, Step S3 of forming a first layer 12, and Step S4 of ramping up the temperature were not implemented.

Specifically, a heterosubstrate 11 was prepared in the same way as with Present Invention Example 1 (Step S1). Next, in Step S2 of preparing a source material, graphite in the form of beads having a diameter of 1 mm was prepared. The graphite was mixed uniformly together with the AlN so as to be 3 mass % with respect thereto. Thereafter the mixed substance was calcined 10 hours at 2100°C. A calcined AlN preform with a carbon density of 0.5 mass % and a relative density of 0.30 was thereby prepared.

Next, the crystal-growth apparatus represented in Figs. 4 and 5 was employed to grow AlN crystal onto the major surface of the heterosubstrate 11 by sublimation deposition. Specifically, with the temperature of the heterosubstrate 11 having been brought to 1900°C and the temperature of the source material 17 to 2100°C, the source material 17 was sublimed for 100 hours. An AlN laminate in Comparative Example 1, furnished with a heterosubstrate and AlN crystal formed onto the heterosubstrate, was thereby obtained.

### Characterization Methods

The AlN laminates of Present Invention Examples 1 through 5 and Comparative Example 1 were taken out of the crystal-growth apparatus after the inside of the crystal-growth apparatus had been cooled down to room temperature. The external appearance of each of the AlN laminates was observed, and the FWHM of each was determined. As to the external appearance, whether the first and second layers had formed so as to cover the heterosubstrate globally was observed visually. As to the FWHMs, the (002) planes of the second layers were characterized by XRD (x-ray diffractometry) rocking-curve measurements.

Further, the density of carbon as an impurity in the first and second layers in the AlN laminates of Present Invention Examples 1 through 5 was determined. The carbon density was measured by SIMS. The various results are set forth in Table I presented below.

**Table I**

| | Impurity concentration (atm/cm³) | | FWHM (arcsec) | Outward appearance |
|---|---|---|---|---|
| | First layer | Second layer | | |
| Pres. Invent. Ex. 1 | 3.5 × 10²⁰ | 8.5 × 10¹⁸ | 300 | Good |
| Pres. Invent. Ex. 2 | 3.0 × 10²⁰ | 5.0 × 10¹⁸ | 300 | Good |
| Pres. Invent. Ex. 3 | 1.5 × 10²⁰ | 3.0 × 10¹⁸ | 100 | Good |
| Pres. Invent. Ex. 4 | 1.5 × 10²⁰ | 1.0 × 10¹⁸ | 100 | Good |
| Pres. Invent. Ex. 5 | 3.0 × 10²⁰ | 5.0 × 10¹⁸ | 300 | Good |
| Comparative Ex. 1 | - | - | - | Growth in center only |

### Characterization Results

With regard to the AlN laminates of Present Invention Examples 1 through 5, the faces 12*a* of the first layers 12 were flat. Further, the first and second layers 12 and 13 had formed globally over the major surfaces 11*a* of the heterosubstrates 11.

What is more, with the FWHMs of the second layers in the AlN laminates of Present Invention Examples 1 through 5 being 300 arcsec or less, the crystalline quality was improved dramatically over that, according to the FWHMs, of the AlN crystal of Non-Patent Reference 1. Particularly in Present Invention Examples 3 and 4, in which the graphite was in the form of rectangular bars, with the FWHMs being not greater than 100 arcsec, extraordinarily favorable crystalline quality was exhibited.

And with Present Invention Examples 2 through 4, in which source materials with an AlN relative density of 0.30 were prepared, the growth rate of the second layer was more rapid than with Present Invention Examples 1 and 5, in which the AlN relative density was 0.56 or greater. From these facts it was understood that in implementations in which the relative density of the AlN in the source material prepared is not greater than 0.55, the growth rate can be heightened.

On the other hand, with the AlN laminate of Comparative Example 1, because the crystal growth was conducted at high temperature, the peripheral margin of the heterosubstrate ultimately sublimated. Consequently, AlN crystal did not grow globally over the prepared heterosubstrate; AlN crystal grew in a region of approximately 15 mm diameter in the midportion of the heterosubstrate.

The foregoing allowed it to be confirmed that, in accordance with the present embodiment, by providing a step of forming a first layer with a flat face, and a step of forming onto the face of the first layer a second layer made of AlN, and by forming the second layer at a higher temperature than the first layer is, a second layer with a large surface area and of excellent crystalline quality can be grown.

### Embodiment 2

In the present embodiment, the effects of forming a second layer 13 in such a way that the concentration of impurities in the second layer 13 would be less than 10¹⁸ atoms•cm⁻³ was investigated.

To begin with, as the heterosubstrate, a 6H-SiC substrate having a one-inch diameter was prepared (Step S1).

Next a source material containing AlN and a Group 4B impurity(ies) was prepared (Step S2). In Step S2, a graphite powder having a grain size of not greater than 2.5 µm was mixed uniformly together with the AlN so as to be 2 mass % with respect thereto, and the mixture was hardened by CIP (cold isostatic pressing) until the relative density of the AlN became 0.40. Here, the relative density was found, in the same way as with Embodiment 1, by Archimedes' principle.

Next, the prepared heterosubstrate 11 was emplaced in the upper part of the crucible 115 in the reaction chamber 122 interior, as illustrated in Figs. 4 and 5, and the just-described source material was lodged into the lower part of the crucible 115.

Then, AlN crystal was grown onto the major surface 11*a* of the heterosubstrate 11 by sublimation deposition, whereby a first layer 12 with a flat face was formed (Step S3).

Specifically, in Step S3, while 100 sccm gaseous nitrogen was flowed in the reaction chamber 122 interior, the RF-power heating coil 123 was employed to elevate the temperature inside the crucible 115 and bring the temperature of the heterosubstrate 11 to 1800°C and the temperature of the source material 17 to 2100°C, to sublime the source material 17 and recrystallize a first layer 12 made of AlN crystal on the major surface of the heterosubstrate 11.

In the present embodiment, eight experiments, in which the growth time (*t₂* - *t₁*) in Step S3 was changed in 10-hour increments from 30 hours up to 100 hours, were carried out.

Next, at a ramp rate of 1°C/min the temperature of the heterosubstrate 11 was ramped up to 2200°C, and the temperature of the source material 17, to 2300°C (Step S4).

In turn, a second layer 13, made of AlN, was formed by sublimation growth onto the face 12*a* of the first layer 12 (Step S5). The growth time in Step S5 here was made 100 hours.

Here, throughout the AlN crystal growth in Steps S3 and S5, the amount of gas exhausted was controlled so that the partial pressure of the gaseous nitrogen in the reaction chamber 122 interior would be 40 to 90 kPa.

The foregoing Steps S1 through S5 were carried out to manufacture eight different AlN laminates 10.

The density of carbon as an impurity in the second layers 13 in the AlN laminates grown as the eight kinds was determined by SIMS. Likewise, the (002) planes of the second layers in the AlN laminates grown as the eight kinds were characterized by XRD. The results are plotted in Fig. 7.

Fig. 7 is a chart illustrating the relationship between impurity concentration in, and FWHM for, the second layer in the present embodiment. The data points within Fig. 7 amount to eight points, with the times in Step S3 being, from the point on the left end, 100, 90, 80, 70, 60, 50, 40 and 30 hours.

It was evident that, as indicated in Fig. 7, lengthening the time in Step S3 made it possible to decrease the impurities in the second layer and to improve its crystalline quality. Likewise, it was evident that forming the second layer 13 in such a way that the concentration of impurities in the second layer 13 would be less than 10¹⁸ atoms•cm⁻³ allowed the FWHM to be between 100 arcsec and 300 arcsec, and allowed the crystalline quality to be improved dramatically over that, according to the FWHMs, of the AlN crystal of Non-Patent Reference 1.

The foregoing allowed it to be confirmed that, in accordance with the present embodiment, by forming the second layer 13 in such a way that the concentration of impurities in the second layer 13 would be less than 10¹⁸ atoms•cm⁻³, its crystalline quality could be improved.

The presently disclosed embodying modes and embodiment examples should in all respects be considered to be illustrative and not limiting. The scope of the present invention is set forth not by the foregoing embodying modes but by the scope of the claims, and is intended to include meanings equivalent to the scope of the claims and all modifications within the scope.

### Reference Signs List

10: AlN laminate; 11: heterosubstrate; 11*a*: major surface; 12: first layer; 12*a*: face; 13: second layer; 17: source material; 115: crucible; 119: insulating element; 121*a*, 121*b*: radiation thermometers; 122: reaction chamber; 123: RF-power heating coil

## Claims

1. An AlN crystal growth method comprising:
a step of preparing a source material containing AlN;
a step of preparing a heterosubstrate, the heterosubstrate having a major surface;
a step of forming a first layer with a flat face, by subliming the source material to grow AlN crystal so as to cover the major surface of the heterosubstrate; and
a step of subliming the source material to form onto the face of the first layer a second layer made of AlN; wherein
the second layer is formed at a higher temperature than is the first layer.

2. The AlN crystal growth method set forth in claim 1, wherein in said step of forming a first layer, a first layer containing a Group 4B impurity is formed.

3. The AlN crystal growth method set forth in claim 2, wherein in said step of forming a first layer, the first layer is formed so that the impurity concentration will be 10¹⁸ atoms•cm⁻³ or greater.

4. The AlN crystal growth method set forth in claim 2 or 3, wherein in said step of forming a second layer, a second layer containing a Group 4B impurity is formed.

5. The AlN crystal growth method set forth in claim 4, wherein in said step of forming a second layer, the second layer is formed so that the impurity concentration will be less than 10¹⁸ atoms•cm⁻³.

6. The AlN crystal growth method set forth in any of claims 2 through 5, wherein the form of the impurity is at least either spherical or polyhedral.

7. The AlN crystal growth method set forth in any of claims 2 through 6, wherein in said step of preparing the source material, a source material in which the relative density of the AlN is between 0.20 and 0.55 is prepared.

8. The AlN crystal growth method set forth in any of claims 1 through 7, wherein in said step of forming a first layer, a first layer having a thickness of 300 µm or greater is formed.

9. The AlN crystal growth method set forth in any of claims 1 through 8, wherein the temperature is raised from said step of forming a first layer until said step of forming a second layer in such a way that the temperature ramp therein will be 1°C/minute or less.

10. An AlN laminate grown by the AlN crystal growth method set forth in any of claims 1 through 9, said AlN laminate therein comprising:
a heterosubstrate;
a first layer formed onto said heterosubstrate; and
a second layer formed onto said first layer.

11. The AlN laminate set forth in claim 10, wherein said second layer has a diameter of 25 mm or greater.

12. The AlN laminate set forth in claim 11, wherein said second layer has a diameter of 50 mm or greater.

13. The AlN laminate set forth in claim 12, wherein said second layer has a diameter of 100 mm or greater.
